# EUROPÄISCHE PATENTSCHRIFT

(11) **EP 2 403 974 B1**
(45) Veröffentlichungstag und Bekanntmachung des Hinweises auf die Patenterteilung: **22.04.2015**
(21) Anmeldenummer: 10708519.3
(22) Anmeldetag: 05.03.2010
(51) Int. Cl.: C30B 25/10, C23C 16/27, C23C 16/01, C30B 29/04, C04B 35/52, C04B 37/00, C04B 37/02, B82Y 30/00, B82Y 40/00, C30B 28/14

(54) **SELBSTTRAGENDE CVD-DIAMANTFOLIE UND VERFAHREN ZUR HERSTELLUNG EINER SELBSTTRAGENDEN CVD-DIAMANTFOLIE**
METHOD FOR PRODUCING A SELF-SUPPORTING DIAMOND FILM AND SELF-SUPPORTING DIAMOND FILM
PROCÉDÉ DE FABRICATION D'UNE FEUILLE DE DIAMANT AUTOPORTEUSE ET FEUILLE DE DIAMANT AUTOPORTEUSE

(30) Priorität: 06.03.2009 EP 09154542
(43) Veröffentlichungstag der Anmeldung: 11.01.2012
(73) Patentinhaber: DiaCCon GmbH, 90762 Fürth (DE)
(72) Erfinder: ROSIWAL, Stefan, 96049 Bamberg (DE); FANDREY, Jan, 91052 Erlangen (DE); KELLERMANN, Karsten, 90518 Altdorf (DE); LODES, Matthias, 91058 Erlangen (DE)
(74) Vertreter: Gassner, Wolfgang
(86) Internationale Anmeldenummer: PCT/EP2010/052840
(87) Internationale Veröffentlichungsnummer: WO 2010/100261

(56) Entgegenhaltungen:
- EP-B1- 0 666 338
- CHEN ET AL: "Growth feature of layered self-standing diamond films by DC arc plasma jet CVD" JOURNAL OF CRYSTAL GROWTH, ELSEVIER, AMSTERDAM, NL LNKD- DOI:10.1016/J.JCRYSGRO.2007.08.033, Bd. 309, Nr. 1, 31. Oktober 2007 (2007-10-31), Seiten 86-92, XP022323985 ISSN: 0022-0248
- QI HUA FAN ET AL: "Free-standing diamond film preparation using copper substrate" DIAMOND AND RELATED MATERIALS ELSEVIER SWITZERLAND, Bd. 6, Nr. 2-4, März 1997 (1997-03), Seiten 422-425, XP004161026 ISSN: 0925-9635
- KUCHEYEV S ET AL: "Ultrathick, low-stress nanostructured diamond films" APPLIED PHYSICS LETTERS, AIP, AMERICAN INSTITUTE OF PHYSICS, MELVILLE, NY, US LNKD- DOI:10.1063/1.1943492, Bd. 86, Nr. 22, 25. Mai 2005 (2005-05-25), Seiten 221914-221914, XP012065717 ISSN: 0003-6951

## Beschreibung

Die Erfindung betrifft eine selbsttragende CVD-Diamantfolie. Sie betrifft ferner ein Verfahren zur Herstellung einer selbsttragenden CVD-Diamantfolie.

Die EP 0 666 338 B1 offenbart ein Verfahren zur Herstellung einer selbsttragenden CVD-Diamantfolie. Dabei werden mittels eines CVD-Verfahrens abwechselnd potentiell-konvexe Diamantschichten mit einem Potential einer konvexen Verformung und potentiell-konkave Diamantschichten mit einem Potential einer konkaven Verformung aufeinanderfolgend abgeschieden. Wegen der alternierenden Anordnungen der potentiell-konvexen und der potentiell-konkaven Schichten werden innere Spannungen, welche eine Verformung der selbsttragenden Diamantschicht bewirken können, kompensiert. Die so hergestellte selbsttragende Diamantfolie ist im Wesentlichen eben.

Die EP 0 574 263 A1 offenbart einen mittels eines CVD-Verfahrens hergestellten Diamantfilm. Bei der Herstellung des Diamantfilms werden die Bedingungen so gewählt, dass eine mittlere Kristallgröße innerhalb der einheitlich ausgestalteten Diamantschicht nicht größer als 1 µm ist. Auch damit kann eine unerwünschte Verbiegung bei einer selbsttragenden Diamantfolie vermieden werden.

Die EP 0 561 588 A1 offenbart einen aus mehreren Diamantschichten im CVD-Verfahren hergestellten Diamantfilm, bei dem zwischen den Diamantschichten aus Metall gebildete Keime eingelagert sind. Über eine mittlere Kristallgröße der die Diamantschichten bildenden Diamantkristalle ist in diesem Dokument nichts ausgesagt.

Unterschiedliche Kristallgrößen in den einzelnen Schichten mehrschichtiger, selbsttragender CVD-Diamantfolien lassen sich durch Variieren des Verhältnisses der Vorläuferverbindungen Methan und Wasserstoff in der Gasphase während der Schichtabscheidung erzeugen (G.C. Chen et al, Journal of Crystal Growth 309 (2007) 86-92).

Mit den bekannten Verfahren lassen sich in der Praxis lediglich relativ kleine selbsttragende CVD-Diamantfolien bzw. Diamantfolien herstellen. Großflächige Diamantfolien, beispielsweise mit einem Durchmesser von mehr als 10 cm, weisen meist unerwünschte Krümmungen auf und/oder brechen leicht. Aufgabe der Erfindung ist es, die Nachteile nach dem Stand der Technik zu beseitigen. Es soll insbesondere ein möglichst einfach und kostengünstig durchführbares Verfahren angegeben werden, welches die Herstellung großflächiger robuster selbsttragender CVD-Diamantfolien ermöglicht. Nach einem weiteren Ziel der Erfindung soll eine großflächige und in der Handhabung robuste CVD-Diamantfolie angegeben werden.

Diese Aufgabe wird durch die Merkmale der Ansprüche 1, 7, 10 und 12 gelöst. Zweckmäßige Ausgestaltungen der Erfindung ergeben sich aus den Merkmalen der Ansprüche 2 bis 6, 8, 9 und 11 sowie 13 bis 18.

Nach Maßgabe der Erfindung wird eine selbsttragende Diamantfolie vorgeschlagen, umfassend eine Mehrzahl übereinander lagernder Diamantschichten,
wobei eine Unterseite jeder Diamantschicht aus Diamant mit einer ersten mittleren Kristallgröße von 2 bis 50 nm gebildet ist,
wobei die mittlere Kristallgröße innerhalb der Diamantschicht von der Unterseite hin zu einer Oberseite der Diamantschicht zunimmt und wobei eine zweite mittlere Kristallgröße im Bereich der Oberseite 50 bis 500 nm beträgt.

Die vorgeschlagene selbsttragende CVD-Diamantfolie besteht aus einer Mehrzahl übereinander lagernder Diamantschichten. Jede der Diamantschichten ist gradiert, d. h. eine mittlere Kristallgröße der die Diamantschicht bildenden Diamantkristalle nimmt von einer Unterseite der Diamantschicht zu deren Oberseite hin zu. Dabei beträgt eine erste mittlere Kristallgröße im Bereich der Unterseite 2 bis 50 nm und eine zweite mittlere Kristallgröße im Bereich der Oberseite der Diamantschicht 50 bis 500 nm. Auf der Oberseite einer Diamantschicht lagert eine weitere Unterseite der nächstfolgenden Diamantschicht. Zwischen der Oberseite und der weiteren Unterseite der nächstfolgenden Diamantschicht sind keine heterogenen Keime, beispielsweise Metallkeime oder dgl., eingelagert. Das eröffnet die Möglichkeit, die vorgeschlagene selbsttragende CVD-Diamantfolie auch zur Herstellung von Halbleitern zu verwenden.

Die vorgeschlagene selbsttragende CVD-Diamantfolie ist überraschenderweise äußerst robust. Es können Scheiben mit einem Durchmesser von mehr als 10 cm hergestellt werden. Die hergestellten Scheiben bzw. Diamantfolien zeichnen sich durch eine ausgezeichnete Planheit aus.

Nach einer vorteilhaften Ausgestaltung beträgt die erste mittlere Kristallgröße 2 bis 30 nm, vorzugsweise 5 bis 20 nm. Die zweite mittlere Kristallgröße beträgt zweckmäßigerweise höchstens 200 nm. Weiter hat es sich als zweckmäßig erwiesen, dass die Diamantschicht eine Schichtdicke im Bereich von 10 nm bis 5 µm, vorzugsweise im Bereich von 100 nm bis 2 µm, aufweist. Eine aus den vorgenannten Diamantschichten gebildete selbsttragende CVD-Diamantfolie ist besonders robust. Sie kann in einer Größe von mehr als 100 cm² hergestellt werden.

Des Weiteren hat es sich als zweckmäßig erwiesen, dass eine Gesamtschichtdicke der selbsttragenden CVD-Diamantfolie im Bereich von 20 µm bis 200 µm, vorzugsweise von 40 µm bis 100 µm, ist. Selbsttragende CVD-Diamantfolien der vorgeschlagenen Gesamtschichtdicke sind mechanisch so stabil, dass sie sich gut handhaben lassen.

Nach einer weiteren vorteilhaften Ausgestaltung weist eine Außenseite der selbsttragenden CVD-Diamantfolie eine maximale Rautiefe R_{z} von 0,01 µm bis 4,0 µm auf. - Indem die selbsttragende CVD-Diamantfolie auf zumindest einer ihrer Außenseiten eine besonders glatte Oberfläche aufweist, wird deren Widerstandsfähigkeit gegen einen Bruch erhöht. Die vorgeschlagene selbsttragende CVD-Diamantfolie ist besonders stabil und lässt sich gut handhaben.

Unter der "maximalen mittleren Rautiefe R_{z}" wird die maximale Rauheitsprofilhöhe im Sinne der DIN EN ISO 4287 verstanden. Es handelt sich um die Summe aus der Höhe der größten Profilspitze Rp und der Tiefe des größten Profiltals Rv des Rauheitsprofils innerhalb einer Einzelmessstrecke.

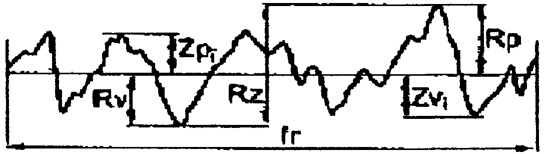

Als senkrechter Abstand vom höchsten zum tiefsten Profilpunkt ist R_{z} ein Maß für die Streubreite der Rauheitsordinatenwerte. R_{z} wird als arithmetisches Mittel aus den maximalen Profilhöhen von fünf Einzelmessstrecken lr im Rauheitsprofil ermittelt.

Die vorgeschlagene selbsttragende CVD-Diamantfolie eignet sich auch zur Herstellung halbleitender Elemente. Zu diesem Zweck kann zumindest eine Diamantschicht mit einer n-Dotierung versehen sein. Die mit der n-Dotierung versehene Diamantschicht kann als Dotierung Stickstoff, Schwefel oder Phosphor enthalten. Weiter kann zumindest eine Diamantschicht mit einer p-Dotierung versehen sein. Die mit der p-Dotierung versehene Diamantschicht kann als Dotierung Bor, Wasserstoff, Indium, Aluminium oder Gallium enthalten.

Zur Erzeugung eines p-n-Übergangs können eine mit der n-Dotierung versehene Diamantschicht und eine mit der p-Dotierung versehene Diamantschicht übereinander abgelagert sein. Nach einer besonders vorteilhaften Ausgestaltung kann eine Diamantschicht 100 ppm bis 20.000 ppm, vorzugsweise 500 ppm bis 2.000 ppm, Bor enthalten.

Nach einer weiteren Ausgestaltung kann es auch sein, dass die selbsttragende CVD-Diamantfolie insgesamt n- oder p-leitend ist. D. h. in diesem Fall können sämtliche Diamantschichten mit einer n- oder einer p-Dotierung versehen sein.

Die erfindungsgemäße selbsttragende CVD-Diamantfolie kann auf zumindest einer ihrer beiden Seiten, vorzugsweise mittels Sputtern, mit einer aus einem Metall hergestellten Metallschicht beschichtet sein. Das Vorsehen einer solchen Metallschicht ermöglicht eine Verbindung der selbsttragenden CVD-Diamantfolie mittels Schweißen, insbesondere Elektronenstrahlschweißen, Laserschweißen oder dgl.

Nach weiterer Maßgabe der Erfindung wird ein Bauteil vorgeschlagen, bei dem eine selbsttragende CVD-Diamantfolie auf zumindest einer Bauteiloberfläche angebracht ist. Damit können die tribologischen Eigenschaften des Bauteils im Bereich der mit der selbsttragenden CVD-Diamantfolie versehenen Bauteiloberflächen erheblich verbessert werden.

Zum Anbringen der Diamantfolie an der Oberfläche kann eine Verbindungsschicht vorgesehen sein. Die Verbindungsschicht ist zweckmäßigerweise so ausgelegt, dass thermisch induzierte Spannungen zwischen der CVD-Diamantfolie und dem Bauteil kompensiert werden. Zu diesem Zweck kann die Verbindungsschicht auch mehrlagig ausgebildet sein. Indem übereinander Lagen, beispielsweise mit einem zunehmenden thermischen Ausdehnungskoeffizienten, geschichtet werden, können besonders große Unterschiede des thermischen Ausdehnungskoeffizienten eines Bauteils gegenüber der selbsttragenden Diamantfolie kompensiert werden.

Bei der Bauteiloberfläche kann es sich auch um eine weitere Außenseite einer weiteren erfindungsgemäßen selbsttragenden CVD-Diamantfolie handeln. D. h. es können mehrere erfindungsgemäße selbsttragende CVD-Diamantfolien, beispielsweise unter Zwischenschaltung einer Carbid-bildenden Metallschicht oder mittels Heißpressen, miteinander verbunden werden. Insbesondere können p- und n-leitende Diamantfolien miteinander verbunden werden. Das ermöglicht die Herstellung thermoelektrischer Bauelemente.

Nach einer vorteilhaften Ausgestaltung der Erfindung ist die Verbindungsschicht aus einem ersten Metall hergestellt. Das erste Metall kann ein Lot sein.

Die Verbindungsschicht kann auch aus einem Polymer, einer Keramik oder einem Glas hergestellt sein. Als besonders zweckmäßig hat es sich erwiesen, dass das Polymer ein präkeramisches Polymer ist. Damit kann eine besonders feste und einfach herstellbare Verbindung zwischen der selbsttragenden Diamantfolie und einer Bauteiloberfläche hergestellt werden.

Nach weiterer Maßgabe der Erfindung wird ein Verfahren zur Herstellung einer erfindungsgemäßen selbsttragenden CVD-Diamantfolie mit folgenden Schritten vorgeschlagen:
Aufbringen von Diamantkeimen auf die Oberfläche eines Substrats,
Einbringen des mit Diamantkeimen versehenen Substrats in eine Reaktionskammer einer CVD-Vorrichtung,
Abscheiden einer Diamantschicht mittels CVD-Verfahrens, wobei während einer ersten Haltezeit von 1 bis 10 Stunden in der Reaktionskammer eine vorgegebene erste Konzentration eines kohlenstoffhaltigen Gases eingestellt wird,
wobei zur Herstellung einer weiteren Diamantschicht aufeinanderfolgend folgende Schritte durchgeführt werden:
   a) Erhöhen der Konzentration des kohlenstoffhaltigen Gases auf eine vorgegebene zweite Konzentration für eine zweite Haltezeit von 20 bis 600 Sekunden, und
   b) Verringern der Konzentration des kohlenstoffhaltigen Gases auf die vorgegebene erste Konzentration und Halten der ersten Konzentration für die erste Haltezeit.

Das vorgeschlagene Verfahren der Herstellung weiterer Diamantschichten lässt sich besonders einfach und kostengünstig durchführen. Es hat sich überraschenderweise herausgestellt, dass bei Einhaltung der im Schritt lit. a) vorgeschlagenen Parameter auf einer relativ grobkristallinen Oberseite einer Diamantschicht wieder eine nächstfolgende Diamantschicht hergestellt werden kann, welche eine feinkristallin ausgebildete Unterseite aufweist. Im Gegensatz zum bisherigen Kenntnisstand ist es dazu nicht erforderlich, beispielsweise aus Metall gebildete Fremdkeime an der Oberseite einer Diamantschicht vorzusehen.

Die Schritte lit. a) und b) können mehrfach wiederholt werden. Es hat sich als zweckmäßig erwiesen, die Schritte lit. a) und lit. b) 10 bis 50 mal, vorzugsweise 15 bis 30 mal, zu wiederholen, so dass eine selbsttragende Diamantfolie 11 bis 50, vorzugsweise 16 bis 30, Diamantschichten aufweist.

Die erste Haltezeit kann 1 bis 4 Stunden betragen. Weiter hat es sich als zweckmäßig erwiesen, dass die erste Konzentration 2,8 bis 4,0%, vorzugsweise 3,0 bis 3,8%, beträgt. Dabei wird zweckmäßigerweise als kohlenstoffhaltiges Gas Methan verwendet.

Weiter hat es sich als zweckmäßig erwiesen, als Substrat ein aus Kupfer, Molybdän, Wolfram oder Silizium hergestelltes Substrat, vorzugsweise einen Silizium-Wafer, zu verwenden. Gerade bei der Verwendung eines Silizium-Wafers gelingt es auf besonders einfache Weise, die selbsttragende Diamantfolie abzulösen.

Weiter hat es sich als vorteilhaft erwiesen, dass eine der Gasatmosphäre ausgesetzte Oberfläche des Substrats eine maximale mittlere Rautiefe R_{z} im Bereich von 0,01 bis 4,0 µm, vorzugsweise von 0,1 bis 0,5 µm, aufweist. Von einer derartigen Oberfläche löst sich beim Abkühlen des Substrats die darauf abgeschiedene Diamantschicht besonders schnell und leicht. Die der Oberfläche zugewandte eine Außenseite der selbsttragenden Diamantfolie ist dann besonders glatt ausgebildet. Deren maximale mittlere Rautiefe korrespondiert zur maximalen mittleren Rautiefe der Oberfläche des Substrats.

Nach einem weiteren vorteilhaften Verfahrensschritt kann die selbsttragende Diamantfolie einer Wärmebehandlung bei einer Temperatur von zumindest 500°C in einer sauerstoffhaltigen Atmosphäre ausgesetzt werden. Damit kann Wasserstoff von der Oberfläche der selbsttragenden Diamantfolie entfernt und durch die Adsorption von Sauerstoff eine polare, hydrophile Oberfläche erzeugt werden. Eine derart modifizierte Oberfläche eignet sich besonders zur Verbindung mit polaren Klebstoffen. Die vorgeschlagene Wärmebehandlung trägt außerdem zur Vergrößerung der Oberfläche bei. Das wiederum unterstützt die mechanische und/oder chemische Anbindung von Klebstoffen.

Nach einer weiteren Ausgestaltung des Verfahrens ist die selbsttragende Diamantfolie auf zumindest einer ihrer beiden Außenseiten, vorzugsweise mittels Sputtern, mit einer aus einem ersten Metall hergestellten Metallschicht beschichtet. Eine solche Metallschicht kann als Elektrode oder auch als Verbindungsschicht zur Herstellung einer Verbindung, beispielsweise mit einer metallischen Oberfläche eines Bauteils, dienen.

Beim "Heißdraht-CVD-Verfahren" werden beispielsweise aus Wolfram hergestellte Heizleiter bzw. Filamente auf Temperaturen im Bereich von 1.700°C bis 2.400°C aufgeheizt. Infolgedessen beträgt zweckmäßigerweise ein Temperatur des Substrats während des Abscheidens der Diamantschichten 600°C bis 1.000°C, zweckmäßigerweise 800°C bis 900°C. Dabei befindet sich das Substrat in einer kohlenstoffhaltigen Gasatmosphäre, welche beispielsweise Methan, Wasserstoff, Sauerstoff und andere Gase enthalten kann. Anstelle des Heißdraht-CVD-Verfahrens kann auch ein Mikrowellen-CVD-Verfahren verwendet werden.

Des Weiteren hat es sich als zweckmäßig erwiesen, gleichzeitig auf einer Vorder- und einer Rückseite des Substrats jeweils eine erfindungsgemäße selbsttragende Diamantfolie herzustellen. Damit kann die Effizienz des vorgeschlagenen Verfahrens verdoppelt werden.

Nachfolgend werden Ausgestaltungen der Erfindung anhand der Zeichnungen näher erläutert. Es zeigen:
- Fig. 1a-f: die Herstellung einer selbsttragenden Diamantfolie sowie eines damit beschichteten Bauteils,
- Fig. 2: eine selbsttragende Diamantfolie mit einer vorgegebenen Form,
- Fig. 3: eine schematische Schnittansicht durch ein mit einer selbsttragenden Diamantfolie beschichtetes Bauteil,
- Fig. 4: eine elektronenmikroskopische Aufnahme einer Oberfläche einer selbsttragenden Diamantfolie,
- Fig. 5: eine elektronenmikroskopische Aufnahme einer Unterseite einer selbsttragenden Diamantfolie,
- Fig. 6: eine elektronenmikroskopische Aufnahme des Schichtaufbaus der selbsttragenden Diamantfolie,
- Fig. 7: ein Raman-Spektrum einer Unterseite einer Diamantschicht und
- Fig. 8: ein Raman-Spektrum einer Oberseite einer Diamantschicht.

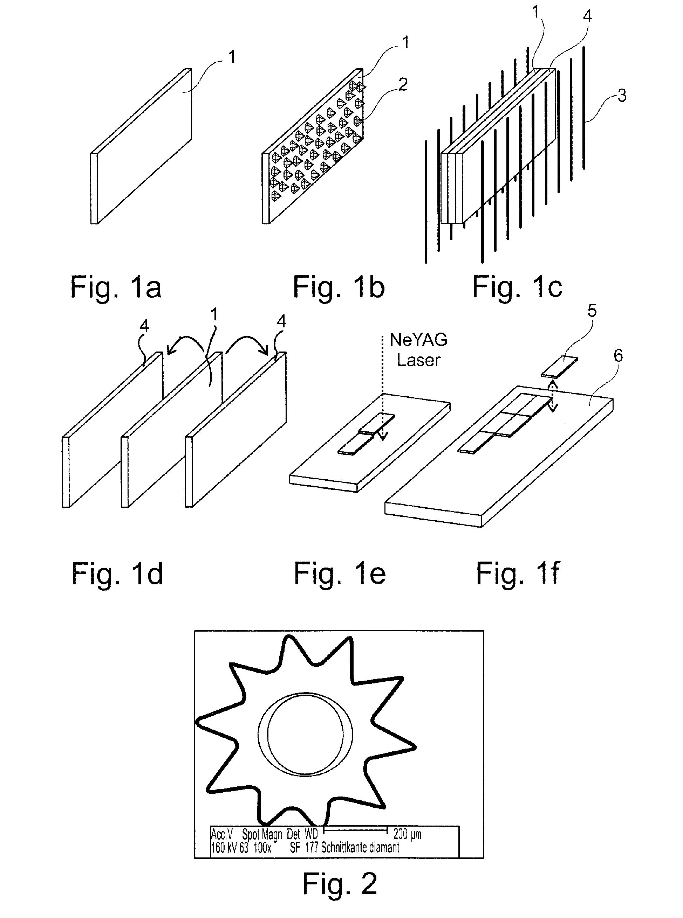

Die Fig. 1a bis d zeigen schematisch die Herstellung einer selbsttragenden Diamantfolie. Zunächst wird ein aus metallischem Kupfer bzw. einer Kupferlegierung hergestelltes Substrat 1 oder ein Silizium-Wafer bereitgestellt (Fig. 1a). Das Substrat 1 weist zumindest an seinen beiden großen Oberflächen eine mittlere Rautiefe R_{z} von beispielsweise 0,2 µm auf. Eine solche mittlere Rautiefe R_{z} kann mittels herkömmlicher Schleif-, Läpp- und Polierverfahren erzeugt werden.

Die Oberfläche des Substrats 1 wird nachfolgend in herkömmlicher Weise im Ultraschallbad mit Diamantkeimen 2, welche eine mittlere Kristallgröße im Bereich weniger Nanometer haben, belegt (siehe Fig. 1b). Das Aufbringen von Diamantkeimen 2 auf die Oberfläche des Substrats 1 kann auch in einer CVD-Reaktionskammer mittels Ionenbeschleunigung auf die Substratoberfläche erfolgen, beispielsweise mittels "biasing". - Bei dem zur Abscheidung der Diamantschicht verwendeten Substrat 1 muss es sich nicht um ein ebenes Substrat 1 handeln. Das Substrat 1 kann auch eine nicht ebene dreidimensionale Form aufweisen, welche ein Ablösen einer darauf abgeschiedenen selbsttragenden CVD-Diamantfolie 4 ermöglicht. Auf diese Weise lassen sich beispielsweise konisch geformte Ringe, selbsttragende Diamantfolien 4 mit Vorsprüngen, welche als Stapelhilfe dienen können, und dgl. herstellen.

Das mit Diamantkeimen 2 belegte Substrat 1, z. B. der Silizium-Wafer, wird so in den CVD-Reaktor (hier nicht gezeigt) gesetzt, dass dessen Heizdrähte 3 etwa parallel zu den zu beschichtenden Seiten des Substrats 1 verlaufen (siehe Fig. 1c). Die Heizdrähte 3 sind vorzugsweise aus W-WC hergestellt. Im CVD-Reaktor wird dann eine im Wesentlichen Methan und Wasserstoff enthaltende Atmosphäre eingestellt. Dabei beträgt eine erste Konzentration an Methan 3,0 bis 4,3%, vorzugsweise 3,4 bis 4,0%. Die Heizleiter 3 werden auf eine Temperatur von 2.000°C bis 2.400°C aufgeheizt. Infolgedessen scheidet sich aus der im CVD-Reaktor befindlichen kohlenstoffhaltigen Atmosphäre auf beiden Oberflächen des Substrats 1 jeweils eine Diamantschicht 8 ab. Beim Heißdraht-CVD-Verfahren werden die Parameter vorzugsweise so gewählt, dass eine mittlere Kristallgröße der die Diamantschicht 8 bildenden Diamantkristalle von 2 bis 30 nm an der Unterseite und bis auf 100 bis 200 nm an der Oberseite zunimmt. Die Temperatur des Substrats 1 beträgt während der Beschichtung etwa 800°C bis 1000°C. Eine Abscheiderate beträgt mehr als 0,1 µm pro Stunde. Sobald die Diamantschicht 8 eine vorgegebene Dicke im Bereich von 1 bis 10 µm erreicht hat, wird die Konzentration des kohlenstoffhaltigen Gases bezogen auf die Gesamtgaszusammensetzung um zumindest 1%, vorzugsweise zumindest 1,5%, erhöht. Es wird beispielsweise eine Methankonzentration von 4,5 bis 5,5% für eine Haltezeit von 60 bis 180 Sekunden eingestellt. Es bilden sich dabei eine extrem feinkörnige Diamantkristalle mit einer mittleren Kristallgröße von 2 bis 50 nm aus, welche eine Unterseite der nächstfolgenden Diamantschicht bilden. Sodann wird die Konzentration des kohlenstoffhaltigen Gases wieder auf die erste Konzentration zurückgenommen. Eine erste Konzentration an Methan wird also wieder auf 3,0 bis 4,3%, vorzugsweise 3,4 bis 4,0%, eingestellt. Die dabei abgeschiedenen Diamantkristalle weisen eine zweite mittlere Kristallgröße im Bereich von 50 bis 500 nm auf. Eine Dicke der bei diesen Bedingungen abgeschiedenen weiteren Diamantschicht beträgt wiederum 1 bis 10 µm. Auf diese Weise können eine Vielzahl übereinander lagernder Diamantschichten abgeschieden werden, welche jeweils an ihrer Unterseite eine erste mittlere Kristallgröße von 2 bis 50 nm aufweisen, wobei die mittlere Kristallgröße zur Oberseite jeder Diamantschicht hin zunimmt und dort eine zweite mittlere Kristallgröße im Bereich von 50 bis 500 nm aufweist. Vorzugsweise beträgt eine zweite mittlere Kristallgröße an der Oberseite lediglich 150 bis 250 nm. Derart können 10 bis 30 übereinanderliegende Diamantschichten abgeschieden werden, so dass eine Gesamtschichtdicke von 20 bis 200 µm, vorzugsweise 40 bis 100 µm, erreicht wird.

Anschließend wird das Substrat 1 auf Umgebungstemperatur abgekühlt. Die auf beiden Seiten des Substrat 1 gebildeten Diamantfolien 4 werden abgelöst. Sie können z. B. mittels eines Nd:YAG-Lasers in vorgegebene geometrische Formen geschnitten werden (Fig. 1e). Es können beispielsweise die in Fig. 1e und 1f gezeigten rechteckigen Folienabschnitte 5 hergestellt werden, welche nachfolgend auf ein Bauteil 6 z. B. mittels eines Polymers geklebt werden können (Fig. 1f).

Fig. 2 zeigt eine Diamantfolie 4, welche mittels eines Nd:YAG-Lasers in die Form eines Zahnrads geschnitten worden ist.

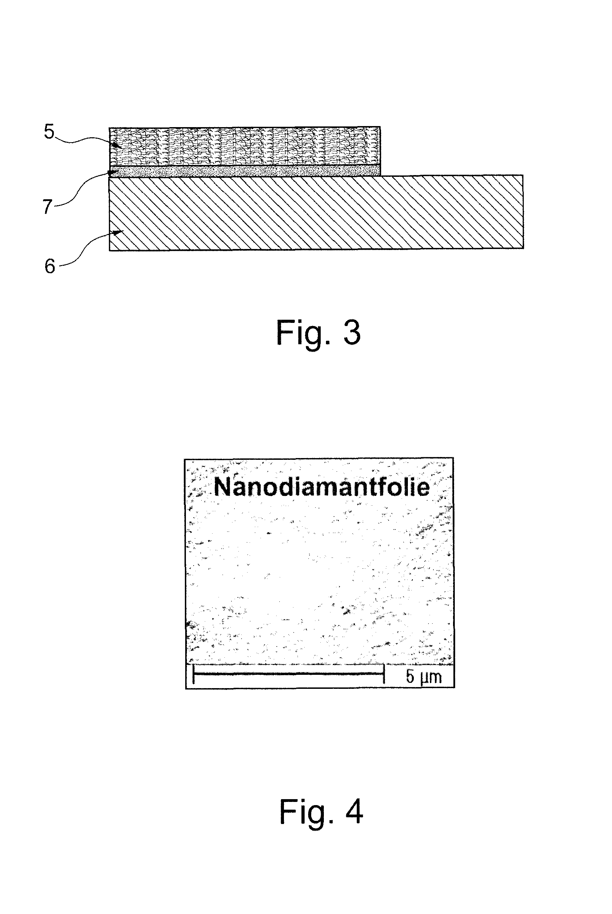

Fig. 3 zeigt eine schematische Querschnittsansicht durch das Bauteil gemäß Fig. 1f. Der Folienabschnitt 5 ist auf das Bauteil 6 mittels einer Polymer-Klebschicht 7 aufgebracht. Anstelle der Polymer-Klebschicht 7 kann auch ein Lot oder dgl. verwendet werden. Ferner ist es zum Verbinden mit einer metallischen Unterlage möglich, die Diamantfolie 4 an ihrer einen Seite z. B. mittels Sputtern mit einer Metallschicht zu versehen. Diese Metallschicht kann sodann beispielsweise mittels Ultraschallschweißen mit der metallischen Unterlage verbunden werden. - Es ist auch möglich, die erfindungsgemäße Diamantfolie 4 unmittelbar mittels Diffusionsschweißen beispielsweise mit einer metallischen Unterlage, insbesondere Aluminium, oder einer weiteren erfindungsgemäßen Diamantfolie zu verbinden.

Fig. 4 zeigt diejenige Seite einer selbsttragenden Diamantfolie, welche während des Heißdraht-CVD-Verfahrens den Heizdrähten 3 zugewandt gewesen ist. Es ist erkennbar, dass hier eine Oberseite der Diamantfolie aus Diamantkristallen gebildet ist, deren mittlere Kristallgröße im Bereich von 100 bis 400 nm liegt.

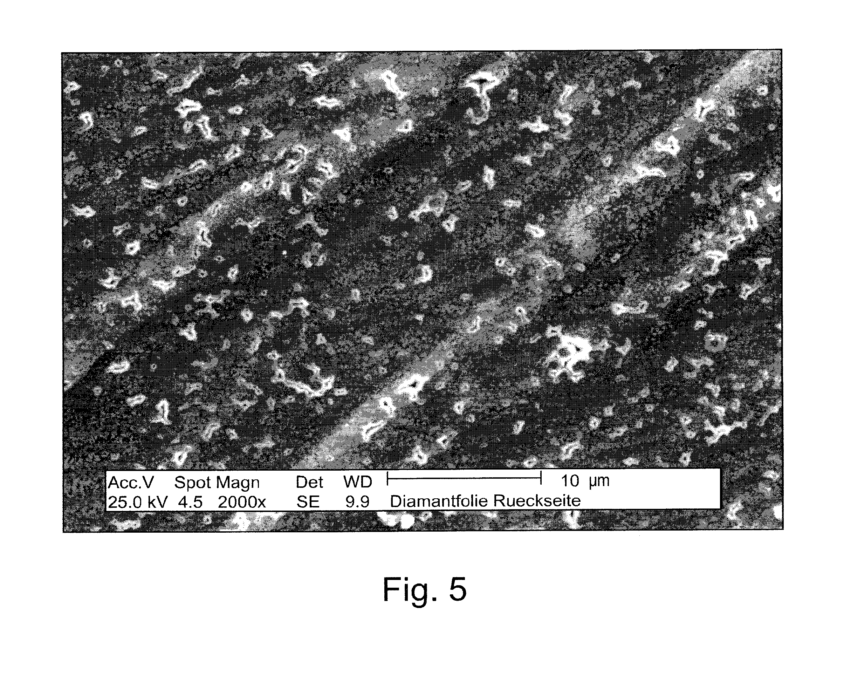

Fig. 5 zeigt die Unterseite einer selbsttragenden Diamantfolie, welche während des Heißdraht-CVD-Verfahrens den Heizdrähten 3 abgewandt gewesen ist. Es handelt sich also um die Kontaktseite zum Substrat 1. Diese Seite der Diamantfolie 4 bildet im Wesentlichen die Morphologie des Substrats 1 ab, d. h. dort sind die Korngrenzen des Substrats 1 abgeformt.

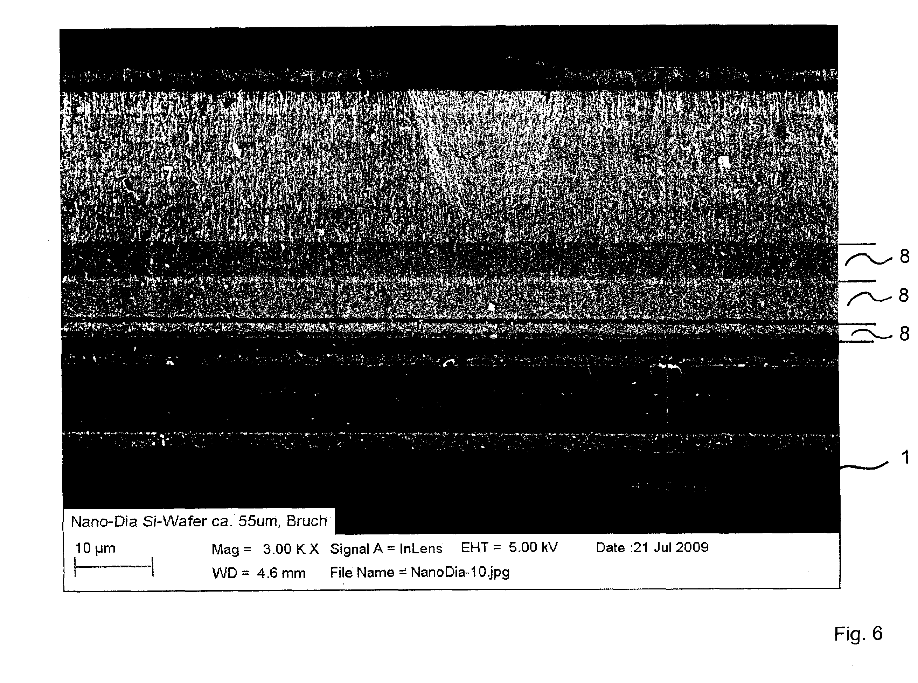

Fig. 6 zeigt eine elektronenmikroskopische Aufnahme des Schichtaufbaus der selbsttragenden Diamantfolie. Auf dem Substrat 1, bei dem es sich beispielsweise um einen Silizium-Wafer handeln kann, sind eine Vielzahl von Diamantschichten 8 abgelagert. Die Diamantschichten 8 weisen eine Dicke im Bereich von 1 bis 7 µm auf. Eine Gesamtschichtdicke aller Diamantschichten 8 beträgt hier etwa 50 µm.

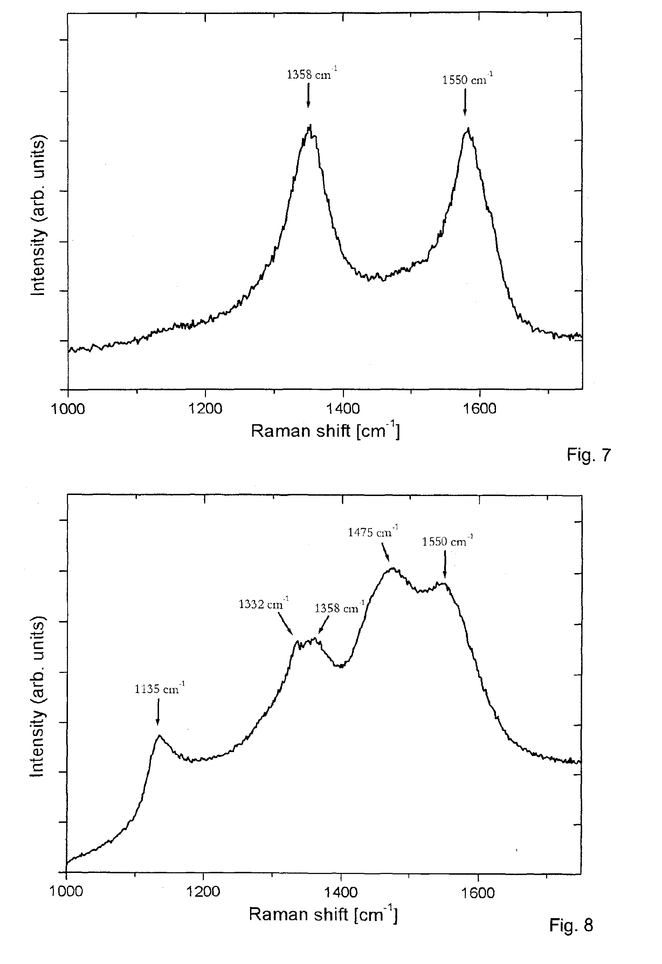

Die Fig. 7 und 8 zeigen Raman-Spektren einer selbsttragenden Diamantfolie 4. Die Raman-Spektren sind unter Verwendung eines Argonionen-Lasers mit einer Wellenlänge von 514,5 nm aufgenommen worden.

Fig. 7 zeigt ein Raman-Spektrum einer Unterseite der ersten Diamantschicht 8, welche unter Verwendung der auf dem Substrat 1 aufgebrachten Diamantkeime 2 hergestellt worden ist. Das Spektrum zeigt im Wesentlichen 2 Intensitätsmaxima bei etwa 1358 cm⁻¹ und 1550 cm⁻¹ auf.

Fig. 8 zeigt ein Raman-Spektrum, welches an der obersten Oberseite der Diamantschichten 8 aufgenommen worden ist. Neben den vorerwähnten Intensitätsmaxima sind hier weitere Intensitätsmaxima, insbesondere bei 1135 cm⁻¹, 1332 cm⁻² und 1475 cm⁻¹, erkennbar.

### Bezugszeichenliste

- 1: Substrat
- 2: Diamantkeim
- 3: Heizdraht
- 4: Diamantfolie
- 5: Folienabschnitt
- 6: Bauteil
- 7: Polymer-Klebschicht
- 8: Diamantschicht

- R_{z}: Rautiefe

## Patentansprüche

1. Selbsttragende CVD-Diamantfolie, umfassend eine Mehrzahl übereinander lagernder Diamantschichten (8),
wobei eine Unterseite jeder Diamantschicht (8) aus Diamant mit einer ersten mittleren Kristallgröße von 2 bis 50 nm gebildet ist,
wobei die mittlere Kristallgröße innerhalb der Diamantschicht (8) von der Unterseite hin zu einer Oberseite der Diamantschicht (8) zunimmt und
wobei eine zweite mittlere Kristallgröße im Bereich der Oberseite 50 bis 500 nm beträgt.

2. Selbsttragende CVD-Diamantfolie nach Anspruch 1, wobei die erste mittlere Kristallgröße 2 bis 30 nm, vorzugsweise 5 bis 20 nm, beträgt.

3. Selbsttragende CVD-Diamantfolie nach Anspruch 1 oder 2, wobei die zweite mittlere Kristallgröße höchstens 200 nm beträgt.

4. Selbsttragende CVD-Diamantfolie nach einem der vorhergehenden Ansprüche, wobei zumindest eine Diamantschicht (8) mit einer n-Dotierung versehen ist.

5. Selbsttragende CVD-Diamantfolie nach einem der vorhergehenden Ansprüche, wobei zumindest eine Diamantschicht (8) mit einer p-Dotierung versehen ist.

6. Selbsttragende CVD-Diamantfolie nach einem der vorhergehenden Ansprüche, wobei sämtliche Diamantschichten mit einer n- oder einer p-Dotierung versehen sind.

7. Bauteil, bei dem eine selbsttragenden Diamantfolie (4) nach einem der vorhergehenden Ansprüche auf zumindest einer Bauteiloberfläche angebracht ist.

8. Bauteil nach Anspruch 7, wobei die Diamantfolie (4) mittels einer Verbindungsschicht (7) an der Bauteiloberfläche angebracht ist.

9. Bauteil nach Anspruch 7 oder 8, wobei die Bauteiloberfläche eine weitere Außenseite einer weiteren selbsttragenden CVD-Diamantfolie nach einem der Ansprüche 1 bis 6 ist.

10. Thermoelektrisches Bauelement, bei dem p- und n-leitende selbsttragende CVD-Diamantfolien nach einem der Ansprüche 4 bis 6 miteinander verbunden sind.

11. Thermoelektrisches Bauelement nach Anspruch 10, wobei die selbsttragenden CDV-Diamantfolien unter Zwischenschaltung einer Carbid-bildenden Metallschicht mit einander verbunden sind.

12. Verfahren zur Herstellung einer selbsttragenden CVD-Diamantfolie (4) nach einem der Ansprüche 1 bis 6 mit folgenden Schritten:
Aufbringen von Diamantkeimen (2) auf die Oberfläche eines Substrats (1),
Einbringen des mit Diamantkeimen (2) versehenen Substrats (1) in eine Reaktionskammer einer CVD-Vorrichtung,
Abscheiden einer Diamantschicht (8) mittels eines CVD-Verfahrens, wobei während einer ersten Haltezeit von 1 bis 10 Stunden in der Reaktionskammer eine vorgegebene erste Konzentration eines kohlenstoffhaltigen Gases eingestellt wird,
**dadurch gekennzeichnet, dass**
zur Herstellung zumindest einer weiteren Diamantschicht (8) aufeinanderfolgend folgende Schritte durchgeführt werden:
a) Erhöhen der Konzentration des kohlenstoffhaltigen Gases auf eine vorgegebene zweite Konzentration für eine zweite Haltezeit von 20 bis 600 Sekunden, und
b) Verringern der Konzentration des kohlenstoffhaltigen Gases auf die vorgegebene erste Konzentration und Halten der ersten Konzentration für die erste Haltezeit.

13. Verfahren nach Anspruch 12, wobei die Schritte lit. a) und b) mehrfach wiederholt werden.

14. Verfahren nach Anspruch 12 oder 13, wobei die erste Haltezeit 1,5 bis 4 Stunden beträgt.

15. Verfahren nach einem der Ansprüche 12 bis 14, wobei die erste Konzentration 2,8 bis 4,0%, vorzugsweise 3,0 bis 3,8%, beträgt.

16. Verfahren nach einem der Ansprüche 12 bis 15, wobei die Temperatur des Substrats (1) während des Abscheidens der Diamantschichten (8) 600 bis 1.000°C beträgt.

17. Verfahren nach einem der Ansprüche 12 bis 16, wobei als Substrat (1) ein aus Kupfer, Molybdän, Wolfram oder Silizium hergestelltes Substrat, vorzugsweise ein Silizium-Wafer, verwendet wird.

18. Verfahren nach einem der Ansprüche 12 bis 17, wobei die selbsttragende Diamantfolie einer Wärmebehandlung bei einer Temperatur von zumindest 500°C in einer sauerstoffhaltigen Atmosphäre ausgesetzt wird.

## Claims

1. Self-supporting CVD diamond film, comprising a plurality of diamond layers (8) stacked one on top of the other, wherein an underside of each diamond layer (8) is formed from diamond with a first average crystal size of 2 to 50 nm, wherein the average crystal size inside the diamond layer (8) increases from the underside to a top side of the diamond layer (8) and wherein a second average crystal size in the region of the top side is 50 to 500 nm.

2. Self-supporting CVD diamond film according to claim 1, wherein the first average crystal size is 2 to 30 nm, preferably 5 to 20 nm.

3. Self-supporting CVD diamond film according to claim 1 or 2, wherein the second average crystal size is no more than 200 nm.

4. Self-supporting CVD diamond film according to one of the preceding claims, wherein at least one diamond layer (8) is provided with an n-doping.

5. Self-supporting CVD diamond film according to one of the preceding claims, wherein at least one diamond layer (8) is provided with a p-doping.

6. Self-supporting CVD diamond film according to one of the preceding claims, wherein all of the diamond layers are provided with an n-doping or a p-doping.

7. Component in which a self-supporting diamond film (4) according to one of the preceding claims is applied to at least one component surface.

8. Component according to claim 7, wherein the diamond film (4) is applied on the component surface by means of a connecting layer (7).

9. Component according to claim 7 or 8, wherein the component surface is a further outside of a further self-supporting CVD diamond film according to one of claims 1 through 6.

10. Thermoelectric component in which p- and n-conducting self supporting CVD diamond films according to one of claims 4 through 6 are connected to one another.

11. Thermoelectric component of claim 10, wherein the self-supporting CVD diamond films are connected with the interposition of a carbide-forming metal layer.

12. Method for producing a self-supporting CVD diamond film (4) according to one of claims 1 through 6 with the following steps:
Application of diamond nuclei (2) onto the surface of a substrate (1),
Insertion of the substrate (1) provided with the diamond nuclei (2) into a reaction chamber of a CVD device,
Deposition of a diamond layer (8) by means of a CVD method, wherein during a first dwell time of 1 to 10 hours in the reaction chamber a predetermined first concentration of a carbonaceous gas is adjusted,
**characterized in that** to produce at least one further diamond layer (8), the following steps are carried out in succession:
a) Increase of the concentration of the carbonaceous gas to a predetermined second concentration for a second dwell time of 20 to 600 seconds and
b) Reduction of the concentration of the carbonaceous gas to the predetermined first concentration and maintenance of the first concentration for the first dwell time.

13. Method according to claim 12, wherein the steps lit. a) and b) are repeated several times.

14. Method according to claim 12 or 13, wherein the first dwell time is 1.5 to 4 hours.

15. Method according to one of claims 12 through 14, wherein the first concentration is 2.8 to 4.0%, preferably 3.0 to 3.8%.

16. Method according to one of claims 12 through 15, wherein the temperature of the substrate (1) is 600ºC to 1,000ºC during the deposition of the diamond layers.

17. Method according to one of claims 12 through 16, wherein as a substrate (1) a substrate of copper, molybdenum, tungsten or silicon, preferably a silicon wafer is used.

18. Method according to one of claims 12 through 17, wherein the self-supporting diamond film is exposed to a heat treatment at a temperature of at least 500ºC in an oxygen-containing atmosphere.

## Revendications

1. Feuille diamantée autoportante obtenue par dépôt chimique en phase vapeur, comprenant un empilement d'une pluralité de couches de diamant (8),
où une face inférieure de chaque couche de diamant (8) est formée de diamant aves une première taille moyenne de cristaux comprise entre 2 et 50 nm,
où la taille moyenne de cristaux dans la couche de diamant (8) augmente de la face inférieure à une face supérieure de la couche de diamant (8) et
où une seconde taille moyenne de cristaux au niveau de la face supérieure est de 50 à 500 nm.

2. Feuille diamantée autoportante obtenue par dépôt chimique en phase vapeur selon la revendication 1, où la première taille moyenne de cristaux est comprise entre 2 et 30 nm, de préférence entre 5 et 20 nm.

3. Feuille diamantée autoportante obtenue par dépôt chimique en phase vapeur selon la revendication 1 ou 2, où la seconde taille moyenne de cristaux est au maximum de 200 nm.

4. Feuille diamantée autoportante obtenue par dépôt chimique en phase vapeur selon l'une des revendications précédentes, où au moins une couche de diamant (8) est munie d'un dopage de type n.

5. Feuille diamantée autoportante obtenue par dépôt chimique en phase vapeur selon l'une des revendications précédentes, où au moins une couche de diamant (8) est munie d'un dopage de type p.

6. Feuille diamantée autoportante obtenue par dépôt chimique en phase vapeur selon l'une des revendications précédentes, où toutes les couches de diamant sont munies d'un dopage de type n ou p.

7. Composant présentant une feuille diamantée autoportante (4) selon l'une des revendications précédentes qui est appliquée sur au moins une surface du composant.

8. Composant selon la revendication 7, où la feuille diamantée est appliquée au moyen d'une couche de liaison (7) à la surface du composant.

9. Composant selon la revendication 7 ou 8, où la surface du composant est une autre face extérieure d'une autre feuille diamantée autoportante obtenue par dépôt chimique en phase vapeur selon l'une des revendications 1 à 6.

10. Composant thermoélectrique présentant des feuilles diamantées autoportantes obtenues par dépôt chimique en phase vapeur conductrices de type p et n qui sont reliées entre elles selon l'une des revendications 4 à 6.

11. Composant thermoélectrique selon la revendication 10, où les feuilles diamantées autoportantes obtenues par dépôt chimique en phase vapeur sont reliées entre elles par interposition d'une couche métallique formant un carbure.

12. Procédé de fabrication d'une feuille diamantée autoportante obtenue par dépôt chimique en phase vapeur (4) selon l'une des revendications 1 à 6 comprenant les étapes suivantes:
application de germes de diamant (2) sur la surface d'un substrat (1),
introduction du substrat (1) muni de germes de diamant (2) dans une chambre de réaction d'un dispositif de dépôt chimique en phase vapeur,
dépôt d'une couche de diamant (8) au moyen d'un procédé de dépôt chimique en phase vapeur, une première concentration prédéterminée d'un gaz carboné étant définie durant un premier temps de maintien compris entre 1 à 10 heures dans la chambre de réaction,
**caractérisé en ce que**
les étapes suivantes sont effectuées successivement pour la fabrication d'au moins une autre couche de diamant (8):
a) augmentation de la concentration du gaz carboné à une seconde concentration prédéterminée pour un second temps de maintien compris entre 20 et 600 secondes, et
b) réduction de la concentration du gaz carboné à la première concentration prédéterminée et maintien de la première concentration pour le premier temps de maintien.

13. Procédé selon la revendication 12, où les étapes points a) et b) sont répétées plusieurs fois.

14. Procédé selon la revendication 12 ou 13, où le premier temps de maintien est compris entre 1,5 et 4 heures.

15. Procédé selon l'une des revendications 12 à 14, où la première concentration est comprise entre 2,8 et 4,0%, de préférence entre 3,0 et 3,8%.

16. Procédé selon l'une des revendications 12 à 15, où la température du substrat (1) est comprise entre 600 et 1000 °C durant le dépôt des couches de diamant (8).

17. Procédé selon l'une des revendications 12 à 16, où un substrat réalisé en cuivre, molybdène, tungstène ou silicium, de préférence une tranche de silicium, est utilisé comme substrat.

18. Procédé selon l'une des revendications 12 à 17, où la feuille diamantée autoportante est soumise à un traitement thermique à une température d'au moins 500 °C dans une atmosphère contenant de l'oxygène.
